# EUROPÄISCHE PATENTSCHRIFT

(11) **EP 1 221 097 B1**
(45) Veröffentlichungstag und Bekanntmachung des Hinweises auf die Patenterteilung: **21.04.2004**
(21) Anmeldenummer: 00975862.4
(22) Anmeldetag: 10.10.2000
(51) Int. Cl.: G06F 11/00

(54) **SCHALTUNGSZELLE ZUR TESTMUSTER-GENERIERUNG UND TESTMUSTER-KOMPRESSION**
CIRCUIT CELL FOR TEST PATTERN GENERATION AND TEST PATTERN COMPRESSION
CELLULE DE CIRCUIT POUR LA GENERATION ET LA COMPRESSION DE MOTIFS DE TEST

(30) Priorität: 11.10.1999 DE 19948902
(43) Veröffentlichungstag der Anmeldung: 10.07.2002
(73) Patentinhaber: Infineon Technologies AG, 81541 München (DE)
(72) Erfinder: SCHÖBER, Volker, 81543 München (DE)
(74) Vertreter: Reinhard - Skuhra - Weise & Partner
(86) Internationale Anmeldenummer: PCT/EP2000/009963
(87) Internationale Veröffentlichungsnummer: WO 2001/027761

(56) Entgegenhaltungen:
- US-A- 5 083 049
- US-A- 5 602 855

## Beschreibung

Die Erfindung betrifft eine Schaltungszelle zur Testmuster-Generierung und Testmuster-Kompression in integrierten Schaltungen mit eingebauter Selbsttestfunktion.

Die US 4740970 beschreibt eine Schaltkreisanordnung zur Verwendung in einem integrierten Schaltkreis mit eingebauter Selbsttestlogik. Zur Erweiterung möglicher Betriebsarten einer BILBO-Registerzelle wird ein Multiplexer vorgesehen, der von einem zusätzlichen Steuersignal angesteuert wird. Der Multiplexer legt in Abhängigkeit von dem Steuersignal entweder ein Dateneingangssignal DI oder ein Datenausgangssignal DO, das zwischengespeichert wird, an ein UND-Gatter an, wobei das Datenausgangssignal DO über eine Rückkopplungsleitung von einem D-Flip-Flop, das einen Datenzwischenspeicher bildet, zu dem Multiplexer zurückgeführt wird.

Die DE 42 21 435 C2 beschreibt einen elektronischen Baustein mit einer taktgesteuerten Schieberegisterprüfarchitektur. In der Prüfeinrichtung ist ein zusätzlicher Betriebsmodus aktivierbar, bei dem mindestens eine Sequenz von einigen Registerelementen ein rückgekoppeltes Schieberegister bilden, das zur Erzeugen einer n-Bit breiten Bitmusterfolge oder zur Signaturbildung aus einem n-Bit breiten, bausteinanschlussseitig den Registerelementen zugeführten Bitmusterfolge ausgebildet ist. Eine Boundary-Scan-Zelle wird dabei derart erweitert, dass sie sich zur Testmustererzeugung oder zur Signaturbildung als rückgekoppeltes Schieberegister anordnen lässt.

Integrierte Schaltungen werden nach der Herstellung in einem Testverfahren zum Testen des logischen und dynamischen Verhaltens unterzogen, um einerseits fehlerhafte Schaltungen zu erkennen und andererseits anhand der Testergebnisse die Leistungsfähigkeit der integrierten Schaltungen zu prüfen. Die integrierten Schaltungen bestehen dabei aus einer Vielzahl von logischen Bauelementen, die ihrerseits aus Schaltelementen bzw. Transistoren bestehen. Hochkomplexe integrierte Schaltungen weisen eine Vielzahl von Schalelementen bzw. Transistoren auf. Bei bekannten Testverfahren werden Stimulations-Testmuster durch einen Testautomaten an die integrierten Schaltungen angelegt und Antwort-Testmuster an den Ausgängen der integrierten Schaltungen durch den Testautomaten ausgelesen und mit einer Soll-Testantwort verglichen. Das Test-Anwortmuster, das von der zu untersuchenden Schaltung (DUT: Device Under Test) abgegeben wird ,muss mit der Soll-Testantwort übereinstimmen damit die integrierte Schaltung als fehlerfrei erkannt wird.

Integrierte Schaltungen werden zunehmend als BIST- (BIST: Built in Selftest) Strukturen mit eingebautem Selbsttest aufgebaut, d.h. in die integrierte Schaltung wird zusätzlich eine Logik implementiert, die Testmustergeneratoren und Testdaten-Auswertemodule umfasst.
Die zu testende integrierte Schaltung wird zur Erleichterung von Testverfahren zunehmend modular aus einer Vielzahl von getrennt testbaren Schaltungseinheiten gebildet, die über einen Datenbus miteinander verbunden sind.

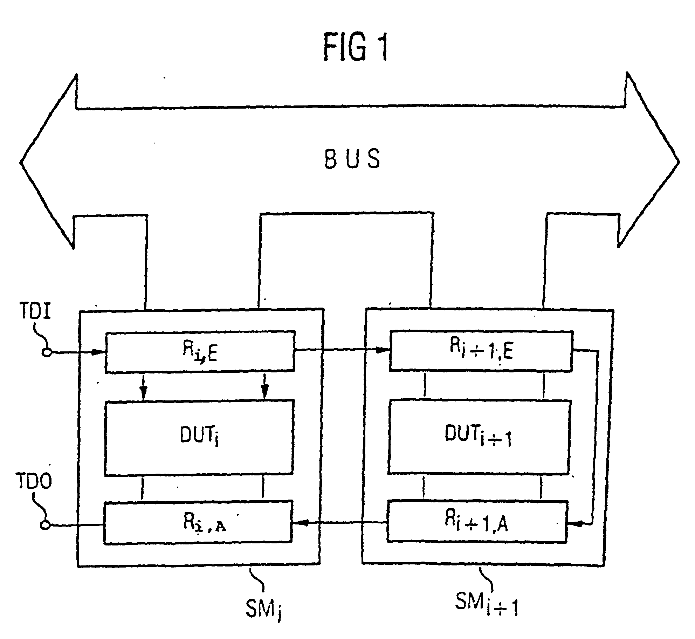

Fig. 1 weist schematisch den Aufbau einer integrierten Schaltung mit eingebauter Selbsttestfunktion, die modular aus einer Vielzahl von Schaltungsmodulen SM aufgebaut ist. Jedes Schaltungsmodul SM besteht aus der eigentlichen zu testenden logischen Schaltung (DUT) und zusätzlich aus zwei BILBO-Registern (BILBO: Built In Logic Block Observation), wobei das erste der beiden BILBO-Register mit den logischen Eingängen der zu testenden logischen Schaltung (DUT) und das andere BILBO-Register mit den logischen Ausgängen der zu testenden logischen Schaltung DUT verbunden ist.

Die in Fig. 1 gezeigten BILBO-Register R sind miteinander in einem seriellen Prüfpfad verbunden. Bei dem in Fig.1 gezeigten Beispiel wird an das Register R_{iE}, das mit den logischen Eingängen der zu testenden logischen Schaltung DUT des Schaltungsmoduls i verbunden ist, ein Testdateneingangsignal TDI angelegt und ein Testdatenausgangssignal TDO an dem Register R_{iA} des Schaltungsmoduls i ausgelesen. Die in Fig. 1 dargestellten Register R_{iE}, das Register R_{i+1, E} das Register R_{i+1, A} sowie das Register R_{iA} wird über Leitungen zu einem seriellen Test-Prüfpfad zusammengeschaltet. Die BILBO-Register R sind Register, die selbständig Testmuster generieren und/oder Testmusterdaten komprimieren können. Herkömmliche BILBO-Register sind zwischen verschiedenen Betriebszuständen umschaltbar. In einem ersten normalen Betriebszustand funktioniert das BILBO-Register als ein Latch, bei dem die am parallelen Daten-Bus anliegenden Daten an die zu testende logische Schaltung DUT angelegt werden oder von der zu testenden logischen Schaltung DUT über den Daten-Bus Datei ausgelesen werden. In einem zweiten Betriebszustand arbeitet das BILBO-Register als ein serielles Schieberegister für die Initialisierung für das Testdatenauslesen bzw. -einlesen. In einem weiteren Betriebszustand werden in dem BILBO-Register Testmuster generiert und gesendet. In einem vierten Betriebszustand werden bearbeitete Testmusterdaten empfangen und zur Testmusterauswertung komprimiert.

BILBO-Register R werden jeweils durch eine Vielzahl von seriell hintereinander geschalteten Schaltungszellen gebildet. Dabei wird jeweils ein Testdateneingang einer BILBO-Schaltungszelle mit dem Testdatenausgang eine davor geschalteten BILBO-Schaltungszelle verbunden.

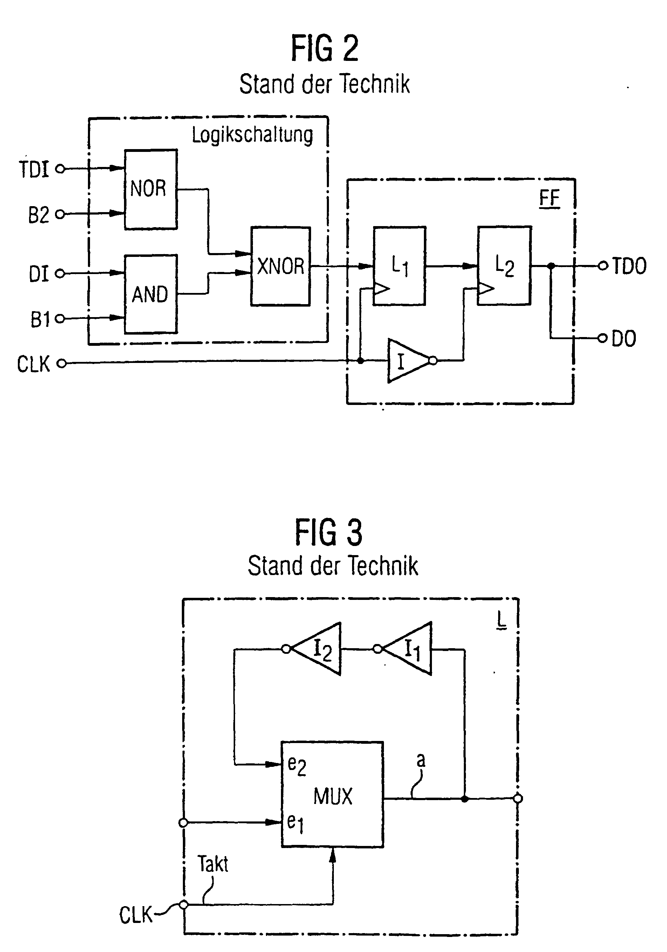

Fig. 2 zeigt eine BILBO-Schaltungszelle zum Aufbau eines BILBO-Registers R nach dem Stand der Technik. Die in Fig. 2 gezeigte BILBO-Schaltungszelle weist zwei Steuersignaleingänge (B1, B2), einen Taktsignaleingang (CLK), einen Dateneingang (DI) und einen Testdateneingang (TDI) auf. Die Steuersignale (B1, B2) werden durch eine Steuerschaltung zum Einstellen des Betriebszustandes des BILBO-Registers R erzeugt. Der Dateneingang DI ist mit einer der parallelen Datenleitungen des internen Datenbusses der integrierten Schaltung verbunden. Der Testdateneingang TDI ist jeweils an den Testdatenausgang der vorangehenden BILBO-Schaltungszelle angeschlossen , wobei an dem Testdateneingang der ersten BILBO-Schaltungszelle ein serielles Testdateneingangssignal zu Testzwecken angelegt wird. Die in Fig. 2 gezeigte BILBO-Schaltungszelle nach dem Stand der Technik enthält einerseits eine aus logischen Gattern aufgebaute Logikschaltung und ein aus zwei Latch-Schaltungen L₁, L₂ aufgebautes Flip-Flop FF auf. Die Logikschaltung besteht dabei aus einem NOR-Gatter, was das zweite Steuersignal B2 logisch NOR mit dem an seriellen Testdatensignaleingang TDI anliegenden Signal verknüpft, einem UND-Gatter, das das am Dateneingang DT anliegende Dateneingangssignal mit dem ersten Steuersignal B1 logisch UND-verknüpft, wobei die Ausgänge des NOR-Gatters und des UND-Gatters jeweils an einem Signaleingang eines XNOR-Gatters angelegt werden, das das logische Ausgangssignal des NOR-Gatters und das logische Ausgangssignal des UND-Gatters in einer XNOR-Operation logisch verknüpft und an den Eingang des ersten Latchs L1 des Flip-Flops FF anlegt. Die beiden Latch-Schaltungen L1, L2 des Flip-Flops FF werden über das am Taktsignaleingang CLK anliegende Taktsignal getaktet, wobei die zweite Latch-Schaltung L₂ des Flip-Flops ein durch einen Inverter I gegenüber dem an der Latch-Schaltung L₁ anliegenden Taktsignal invertiertes Taktsignal empfängt.

Fig. 3 zeigt den internen Aufbau einer herkömmlichen Latch-Schaltung L nach dem Stand der Technik im Detail. Die Latch-Schaltung L weist einen Multiplexer MUX mit zwei Signaleingängen und einem Signalausgang auf. An dem ersten Eingang des Multiplexers MUX erhält die Latch-Schaltung ein Dateneingangssignal, das an den Ausgang a des Multiplexers MUX getaktet durch das an dem Taktsignaleingang anliegende Taktsignal durchgeschaltet wird. Der Ausgang a des Multiplexers ist über zwei Inverter I1, I2 zum Halten des Eingangssignals an dem zweiten Eingang e2 des Multiplexers MUX rückgekoppelt. Die Latchschaltung L ist taktzustandsgesteuert, wobei beim Aktivieren des Taktsignals CLK das am Eingang e1 anliegende Bit an den Ausgang a übertragen wird und gleichzeitig in der Rückkopplungsschleife statisch gespeichert wird.

Die in Fig. 2 dargestellte Logik-Schaltung, die einen Teil der BILBO-Schaltungszelle nach dem Stand der Technik bildet und aus dem NOR-Gatter, dem UND-Gatter sowie dem XNOR-Gatter besteht, entspricht funktionell einem XOR-Gatter mit einem, Multiplexer. Der Multiplexer ist dabei in den Datensignalpfad zwischen dem Datensignaleingang DI und dem Datenausgang DO der in Fig. 2 gezeigten Schaltungszelle geschaltet. Aufgrund der in dem Datensignalpfad geschalteten logischen Gatter kommt es bei der Schaltungszelle für ein BILBO-Register wie es in Fig. 2 dargestellt ist, zu Laufzeit-Signalverzögerungen, die die Schaltzeit der Schaltungszelle erhöhen. Die in Fig. 2 gezeigte Logikschaltung zum Einkoppeln der Testdaten in den Datensignalpfad führt somit zu einer unerwünschten Reduzierung der Schaltgeschwindigkeit des BILBO-Registers. Aufgrund der verminderten Schaltgeschwindigkeit der BILBO-Register verzögert sich der Testvorgang zum Testen der integrierten Schaltungen erheblich.

Es ist daher die Aufgabe der vorliegenden Erfindung eine Schaltungszelle zum Aufbau eines Registers zu Testzwecken zu schaffen, das eine hohe Schaltgeschwindigkeit aufweist.

Diese Aufgabe wird erfindungsgemäß durch eine Schaltungszelle mit den im Patentanspruch 1 angegebenen Merkmalen gelöst.

Weitere vorteilhafte Weiterbildungen der erfindungsgemäßen Schaltungszelle sind in den Unteransprüchen angegeben.

Die Erfindung schafft eine Schaltungszelle zur Testmuster-Generierung und Testmusterkompressipn in Schaltungen mit eingebauter Selbsttestfunktion,
wobei die Schaltungszelle aufweist:
eine Testdaten-Einkoppelschaltung mit einem Testdateneingang zum Empfangen eines Testdateneingangssignals von einer vorgeschalteten Speicherzelle, das in einem Testdaten-Zwischenspeicher abspeicherbar ist,
einem Dateneingang zum Anlegen eines Dateneingangssignals, das in einem Datenzwischenspeicher abspeicherbar ist
einem Testdatenausgang zur Abgabe des zwischengespeicherten Testdatensignals und mit
einem Datenausgang zur Abgabe des zwischengespeicherten Datensignals an einen Datensignalpfad über einen Datensignalausgang der Speicherzelle,
wobei die beiden Zwischenspeicher der Testdaten-Einkoppelschaltung einen gemeinsamen Rückkopplungs-Signalpfad aufweisen, über den das empfangene Testdateneingangssignal in den Datensignalpfad in Abhängigkeit von einem an der Testdaten-Einkoppelschaltung angelegten ersten Steuersignal einkoppelbar ist,
wobei die Schaltungszelle ferner eine logische Vergleichsschaltung aufweist, die das Testdateneingangssignal mit dem von der Testdaten-Einkoppelschaltung abgegebenen Testdatensignal zum Erzeugen eines Vergleichssignals vergleicht, das an eine Schalteinrichtung abgegeben wird, die in Abhängigkeit von einem zweiten Steuersignal das erzeugte Vergleichssignal oder das von der Testdaten-Einkoppelschaltung abgegebene Testdatensignal an einen Testdatensignalausgang der Speicherzelle durchschaltet.

Die Grundidee bei der erfindungsgemäßen Schaltungszelle besteht darin, die Testdaten über einen gemeinsamen Rückkopplungs-Signalpfad zweier Zwischenspeicher in den Datensignalpfad einzukoppeln und so die Anzahl der seriell in den Datensignalpfad hintereinander geschalteten Schaltungsbauelemente zur Verminderung der Signallaufzeit-Verzögerung zu minimieren.

Bei einer bevorzugten Weiterbildung der erfindungsgemäßen Schaltungszelle wird jeweils der Testdatensignalausgang einer Schaltungszelle mit dem Testdateneingang einer nachgeschalteten Schaltungszelle zum Aufbau eins BILBO-Registers verbunden.

Die beiden Zwischenspeicher der Testdaten-Einkoppelschaltung sind vorzugsweise Latch-Schaltungen, die jeweils aus einem Multiplexer und einen Rückkopplungs-Multiplexer zum Rückkoppeln der Signalausgänge der Multiplexer an einen Signaleingang des Multiplexers bestehen.

Der Rückkopplungs-Multiplexer weist vorzugsweise zwei Signaleingänge auf, wobei der erste Signaleingang mit dem Signalausgang des Multiplexers des Testdaten-Zwischenspeichers und der zweite Signaleingang mit dem Signalausgang des Multiplexers des Daten-Zwischenspeichers verbunden ist, und wobei der Rückkopplungs-Multiplexer durch das erste Steuersignal derart steuerbar ist, dass der Multiplexerausgang des Multiplexers des Testdaten-Zwischenspeichers an einem Signaleingang des Multiplexers des Daten-Zwischenspeichers zum Einkoppeln der Testdaten in den Datensignalpfad geschaltet wird.

Bei einer bevorzugten Weiterbildung der erfindungsgemäßen Schaltungszelle weist der Multiplexer des Testdaten-Zwischenspeichers zwei schaltbare Signaleingänge auf, wobei an den ersten Signaleingang das Testdateneingangssignal anliegt und der zweite Signaleingang mit dem Signalausgang des Rückkopplungs-Multiplexers verbunden ist.

Gemäß einer weiteren bevorzugten Weiterbildung der erfindungsgemäßen Schaltungszelle weist der Multiplexer des Daten-Zwischenspeichers zwei schaltbare Signaleingänge auf, wobei an dem ersten Signaleingang das Datensignal anliegt und der zweite Signaleingang mit dem Signalausgang des Rückkopplungs-Multiplexers verbunden ist.

Bei einer bevorzugten Weiterbildung wird die logische Vergleichsschaltung der Schaltungszelle durch ein XOR-Gatter gebildet.

Die Schalteinrichtung zum Durchschalten des erzeugten Vergleichsignals wird bei einer bevorzugten Weiterbildung der erfindungsgemäßen Schaltungszelle durch einen Multiplexer gebildet.

Vorzugsweise ist zwischen dem Datenausgang der Testdaten-Einkoppelschaltung und dem Datensignalausgang der Schaltungszelle ein getakteter Datenausgabe-Zwischenspeicher vorgesehen. Vorzugsweise ist ferner zwischen dem Testdatenausgang der Speicherzelle und der Schalteinrichtung eine getakteter Testdatenausgabe-Zwischenspeicher vorgesehen.

Bei einer bevorzugten Weiterbildung der erfindungsgemäßen Schaltungszelle empfängt die Testdaten-Einkoppelschaltung über einen Taktsignaleingang ein Taktsignal zum Takten der beiden Zwischenspeicher-Multiplexer sowie des Rückkopplungs-Multiplexers.

Der Datenausgabe-Zwischenspeicher und der Testdatenausgabe-Zwischenspeicher empfangen gemäß einer bevorzugten Weiterbildung über einen Taktsignaleingang ein Taktsignal, das invertiert zu dem an den Takteingang der Testdaten-Einkoppelschaltung anliegenden Taktsignal ist.

Das Testdateneingangssignal ist vorzugsweise in einem getakteten Testdateneingabe-Zwischenspeicher zum Vergleichen mit dem Testdatensignal durch die Vergleichsschaltung zwischengespeichert.

Der Datenausgabe-Zwischenspeicher, der Testdatenausgabe-Zwischenspeicher und der Testdateneingabe-Zwischenspeicher werden vorzugsweise jeweils durch eine Latch-Schaltung gebildet, die einen Rückkopplungs-Multiplexer enthält.

Im weiteren wird eine bevorzugte Ausführungsform der erfindungsgemäßen Schaltungszelle zur Testmuster-Generierung und Testmuster-Kompression von Schaltungen mit eingebauter Selbsttestfunktion zur Erläuterung erfindungswesentlicher Merkmale beschrieben.

Es zeigen:
- Fig.1: ein schematisches Blockschaltbild zur Erläuterung des internen Aufbaus einer integrierten Schaltung mit eingebauter Selbsttestfunktion nach dem Stand der Technik;
- Fig.2: eine Schaltungszelle zum seriellen Aufbau eines BILBO-Registers nach dem Stand der Technik;
- Fig.3: den internen Schaltungsaufbau einer Latch-Schaltung nach dem Stand der Technik;
- Fig.4: eine bevorzugte Ausführungsform der erfindungsgemäßen Schaltungszelle;
- Fig.5: den internen Aufbau einer bevorzugten Ausführungsform der Testdaten-Einkoppelschaltung gemäß der Erfindung.

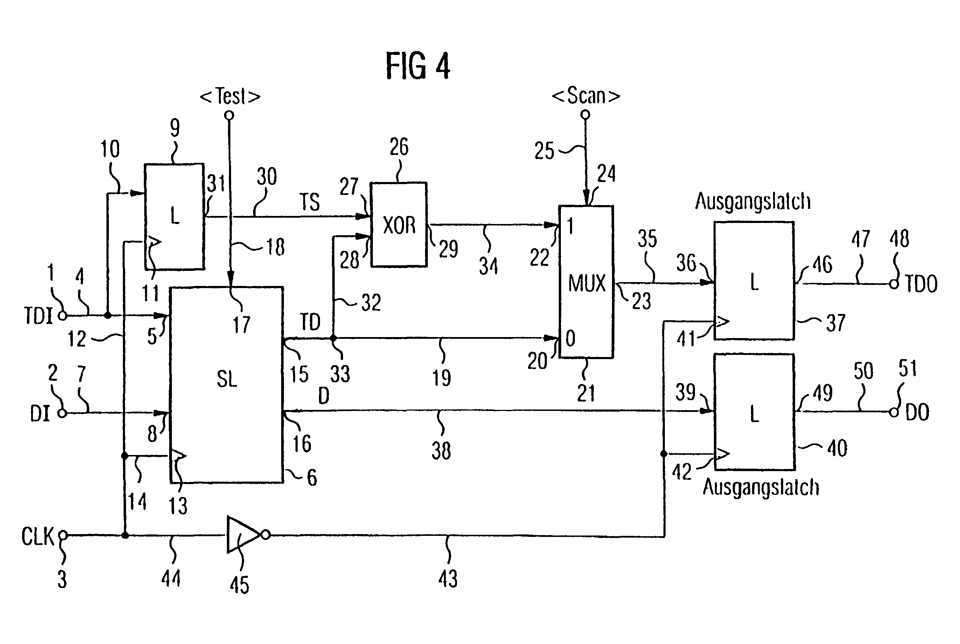

Eine bevorzugte Ausführungsform der erfindungsgemäßen Schaltungszelle 1 der Testmuster-Generierung und Testmusterkompression von integrierten Schaltungen mit eingebauter Selbsttestfunktion ist in Fig. 4 dargestellt.

Die erfindungsgemäße Schaltungszelle 1 weist einen Testdateneingangsanschluss 1 zum Empfangen eines Testdateneingangssignals TDI von einer vorgeschalteten Schaltungszelle, einen Dateneingangsanschluss 2 zum Anlegen eines Dateneingangssignals DI und einen Taktsignaleingang 3 zum Anlegen eins Taktsignals CLK auf. Der Testdateneingang 1 ist über eine interne Leitung 4 mit einem ersten Signaleingang 5 einer Testdateneinkoppelschaltung 6 verbunden. Der Dateneingangsanschluss 2 ist über eine interne Signalleitung 7 mit einem zweiten Signaleingang 8 der Testdateneinkoppelschaltung 6 verbunden. Die erfindungsgemäße Schaltungszelle weist ferner einen Testdateneingabe-Zwischenspeicher 9 auf, der über eine interne Signalleitung 10 an die Testdateneingabeleitung 4 angeschlossen ist. Der Testdateneingabe-Zwischenspeicher 9 ist vorzugsweise eine Latch-Schaltung. Der Testdateneingabe-Zwischenspeicher 9 dient zur Zwischenspeicherung des an dem Anschluß 1 anliegenden Testdateneingangssignals TDI. Der Testdateneingabe-Zwischenspeicher 9 besitzt einen Taktsignaleingang 11, der über eine interne Taktleitung 12 der Schaltungszelle mit dem Taktsignaleingangsanschluss 3 verbunden ist. Die Testdateneinkoppelschaltung 6 besitzt ebenfalls einen Taktsignaleingang 13, der über eine Taktsignalleitung 14 an dem Taktsignaleingang 3 der erfindungsgemäßen Schaltungszelle angeschlossen ist.

Die Testdateneinkoppelschaltung 6 weist zwei Dateneingänge auf, nämlich den Testdateneingang 5 zum Anlegen des Testdateneingangssignals TDI von einer vorgeschalteten Schaltungszelle und den Dateneingang 8 zum Anlegen des Dateneingangssignals DI. Die Testdateneinkoppelschaltung 6 weist ferner zwei Datenausgänge auf, nämlich einen Testdatenausgang 15 zur Abgabe eines internen zwischengespeicherten Testdatensignals und einen Datenausgang 16 zur Abgabe eines in der Testdaten-Einkoppelschaltung 6 zwischengespeicherten Datensignals. Die Testdateneinkoppelschaltung 6 besitzt ferner einen Steueranschluß 17, an dem über eine Steuerleitung 18 ein erstes Steuersignal TEST angelegt wird.

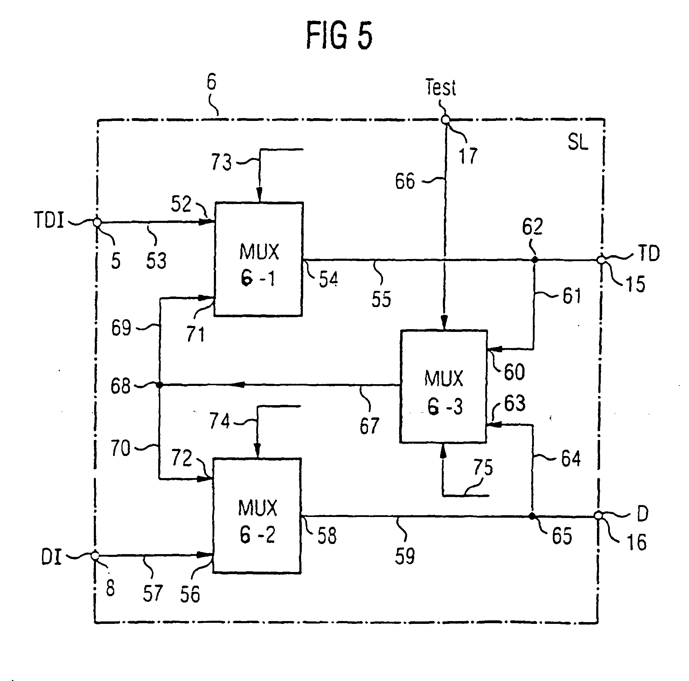

Der interne Aufbau der in Fig. 4 gezeigten Testdateneinkoppelschaltung 6 wird im weiteren noch unter Bezugnahme auf die Fig. 5 im Detail erläutert.

Wie in Figur 4 dargestellt wird das am Testdatenausgang 15 der Testdateneinkoppelschaltung 6 abgegebene zwischengespeicherte Testdatenausgangssignal TD über einen interne Datenleitung 19 der Schaltungszelle einem ersten Signaleingang 20 einer Schalteinrichtung 21 zugeführt. Die Schalteinrichtung 21 ist vorzugsweise ein Multiplexer mit einem ersten Signaleingang 20, einem zweiten Signaleingang 22 und einem Signalausgang 23, wobei über einen Steueranschluß 24 der Schalteinrichtung 21 ein an einer Steuerleitung 25 anliegendes zweites Steuersignal SCAN die Schalteinrichtung 21 derart schaltet, dass entweder der Signaleingang 20 oder der Signaleingang 22 der Schalteinrichtung 21 auf den Signalausgang 23 geschaltet wird.

Die erfindungsgemäße Schaltungszelle weist ferner eine logische Vergleichschaltung 26 mit einem ersten logischen Signaleingang 27, einem logischen Signaleingang 28 und einem logischen Signalausgang 29 auf. Der logische Signaleingang 27 der logischen Vergleichsschaltung 26 ist über einen interne Leitung 30 an einen Signalausgang 31 des Testdateneingabe-Zwischenspeichers 9 angeschlossen. Der zweite logische Signaleingang 28 der logischen Vergleichsschaltung 26 liegt über eine interne Leitung 32 an einem Abzweigungsknoten 33 der Datenleitung 19 zum Empfang des Datenausgangsignals TD der Testdateneinkoppelschaltung 6 an. Die logische Vergleichsschaltung 26 vergleicht das von dem Testdateneingabe-Zwischenspeicher 9 zwischengespeicherte Testdateneingangsignal TS mit dem von der Testdaten-Einkoppelschaltung 6 über den Testdatenausgang 15 abgegebene zwischengespeicherte Testdatensignal TD und erzeugt an dem Vergleichschaltungsausgang 29 ein Vergleichssignal, das über eine interne Leitung 34 an den zweiten Signaleingang 22 der Schalteinrichtung 21 angelegt wird. Die logische Vergleichschaltung 26 wird vorzugsweise durch ein XOR-Gatter zur logischen XOR-Verknüpfung des zwischengespeicherten Testdateneingangsignals TS und des von der Testdateneinkoppelschaltung 6 abgegeben Testdatenausgangssignals TD gebildet.

Der Signalausgang 23 der Schalteinrichtung 21 ist vorzugsweise über eine interne Leitung 35 mit dem Signaleingang 36 eines Testdatenausgabe-Zwischenspeichers 37 verbunden. Der Testdatenausgabe-Zwischenspeicher 37 ist vorzugsweise eine getaktete Latch-Schaltung. Der Datenausgang 16 der Testdateneinkoppelschaltung 6 gibt ein zwischengespeichertes Datensignal D über eine interne Datenleitung 38 an einen Signaleingang 39 eines Datenausgabe-Zwischenspeichers 40 ab. Der Datenausgabe-Zwischenspeicher 40 ist vorzugsweise eine getaktete Latch-Schaltung. Der Testdatenausgabe -Zwischenspeicher 37 und der Datenausgabe-Zwischenspeicher 40 weisen jeweils Taktsignaleingangsanschlüsse 41, 42 auf, die an einer internen Taktsignalleitung 43 angeschlossen sind. Das an dem Taktsignalanschluss 3 der Schaltungszelle anliegende Signal gelangt über eine internen Leitung 44 an eine Inverterschaltung 45, die das invertierte Taktsignal an die beiden Taktsignalanschlüsse 41, 42 des Testdatenausgabe-Zwischenspeichers 37 und des Datenausgabe-Zwischenspeichers 40 anliegt. Der Testdatenausgabe-Zwischenspeicher 37 besitzt einen Signalausgang 46, der das zwischengespeicherte Datenausgabesignal über eine interne Datenausgabesignalleitung 47 an einen Testdatensignalausgang 48 der Schaltungszelle abgibt. Der Datenausgabe-Zwischenspeicher 40 besitzt einen Signalausgang 49, der über eine interne Datensignalausgangsleitung 50 mit einem Datensignalausgangsanschluss 51 der Schaltungszelle verbunden ist.

Fig. 5 zeigt den Schaltungsaufbau einer bevorzugten Ausführungsform der Testdateneinkoppelschaltung 6 gemäß der Erfindung. Bei der in Fig. 5 gezeigten bevorzugten Ausführungsform der Testdateneinkoppelschaltung 6 sind zwei Signalzwischenspeicher zum Zwischenspeichern des an dem Dateneingangsanschluss 5 anliegenden Testdateneingangssignal und des an dem Eingangsanschluß 8 anliegenden Dateneingangssignal DI vorgesehen. Wie man aus Fig. 5 erkennen kann, enthält die Testdateneinkoppelschaltung 6 drei getaktete Multiplexer (6-1, 6-2, 6-3), die jeweils zwei Signaleingänge und einen Signalausgang besitzen. Der erste Signaleingang 52 des ersten Multiplexers 6-1 ist mit dem Testdatensignaleingang 5 über eine interne Leitung 53 verbunden. Der Signalausgang 54 des ersten Multiplexers 6-1 ist über eine interne Leitung 55 mit dem Ausgangsanschluß 15 der Testdateneinkoppelschaltung 6 verbunden. Der erste Eingang 56 des zweiten Multiplexers 6-2 ist über einen interne Datenleitung 57 an den Dateneingangsanschluss 8 angeschlossen und der Signalausgang 58 des zweiten Multiplexers 6-2 liegt über eine Leitung 59 an dem Datenausgang 16 der Testdateneinkoppelschaltung 6 an.

Der dritte Multiplexer 6-3 der Testdateneinkoppelschaltung 6 besitzt einen ersten Signaleingang 60 , der über eine Rückkoppelleitung 61 an einem Abzweigungsknoten 62 der Datenleitung 55 anliegt sowie einen zweiten Dateneingang 63, der über eine Rückkoppelleitung 64 an einem Abzweigungsknoten 65 zur Rückkopplung des Datensignals D anliegt. Der dritte Multiplexer 6-3 wird über eine interne Steuerleitung 66 der Testdateneinkoppelschaltung 6 mit dem ersten Steuersignal TEST gesteuert. In Abhängigkeit von dem anliegenden ersten Steuersignal wird entweder das an der Leitung 55 anliegende Testdatensignal TD oder das an der Leitung 59 anliegende Datensignal D auf eine Rückkoppelleitung 67 geschaltet, die sich an einem Verzweigungsknoten 68 zu einer Leitung 69 und einer Leitung 70 verzweigt. Die verzweigte Rückkoppelleitung 69 liegt an dem zweiten Eingang 71 des ersten Multiplexers 6-1 an. Die verzweigte Rückkoppelleitung 70 liegt an dem zweiten Eingang des zweiten Multiplexers 6-2 an.

Die Multiplexer 6-1, 6-2, 6-3 werden jeweils über Taktleitungen 73, 74,75 mit dem in Fig. 4 dargestellten Taktsignaleingangsanschluss 3 des Testdateneinkoppelschaltung 6 verbunden.

Der erste Multiplexer 6-1 bildet zusammen mit dem Rückkopplungsmultiplexer 6-3 einen Zwischenspeicher zur Zwischenspeicherung des Testdateneingangssignals TDI. Der Rückkopplungs-Multiplexer 6-3 bildet gleichzeitig mit dem zweiten Multiplexer 6-2 einen Zwischenspeicher zum Zwischenspeichern des Dateneingangssignals DI. Die in Fig. 5 gezeigte Testdateneinkoppelschaltung 6 weist also zwei integrierte Latch-Schaltungen auf, wobei die erste Latch-Schaltung durch den ersten Multiplexer 6-1 gebildet wird, der über den Rückkopplungs-Multiplexer 6-3 rückgekoppelt ist und wobei die zweite Latch-Schaltung durch den zweiten Multiplexer6-2 gebildet wird, die ebenfalls über den Rückkopplungs-Multiplexer 6-3 rückgekoppelt ist. Die beiden Zwischenspeicher der Testdateneinkoppelschaltung 6 weisen einen gemeinsamen Rückkopplungs-Signalpfad 67 auf, über den in Abhängigkeit von dem in der Leitung 66 anliegenden Steuersignal TEST, das an dem Testdateneingangsanschluss 5 empfangene Testdateneingangssignal in den Datensignalpfad, der durch die Leitungen 57, 59 gebildet wird, einkoppelbar ist. Der Rückkopplungs-Multiplexer erfüllt bei der erfinduhgsgemäßen Testdaten-Einkoppelschaltung eine Doppelfunktion, nämlich einerseits als Teil der beiden Zwischenspeicherschaltungen und andererseits als Schaltvorrichtung zum Einkoppeln des Testdateneingangsignals in den Datensignalpfad. Ferner können über den Rückkopplungssignalpfad 67 die Testdaten ausgelesen werden.

Die folgende Tabelle stellt die Signale der erfindungsgemäßen Schaltungszelle für die verschiedenen Betriebszustände dar:

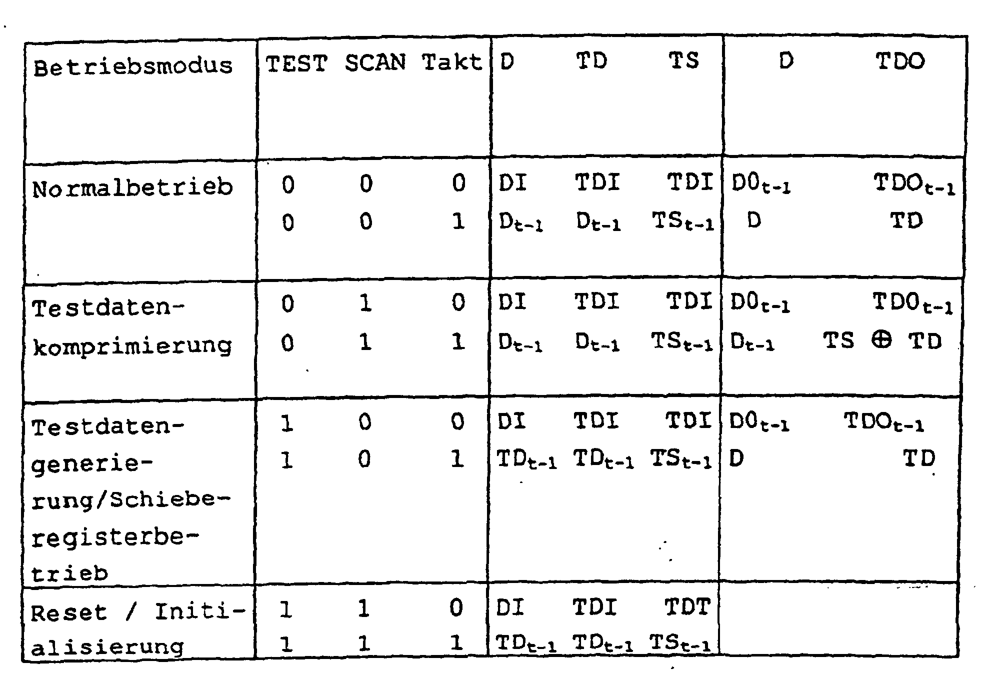

Die erfindungsgemäße Schaltungszelle ist zwischen einem Normalbetrieb, einem Testdatenkomprimierungsbetrieb und einem Testdatengenerierungsbetrieb in Abhängigkeit von den beiden Steuersignalen TEST, SCAN umschaltbar. Wie man aus Fig. 4 erkennen kann, weist die erfindungsgemäße Schaltungszelle zwei Signaleingänge 1,2 und zwei Signalausgänge 48, 51 auf. An dem Testdateneingang 1 ist ein Zwischenspeicher zur Abspeicherung der aktuellen Signatur vorgesehen und an dem Dateneingang 8 ist ein Zwischenspeicher zum Zwischenspeichern des aktuellen Datums vorgesehen. Am Datenausgangsanschluss 51 befindet sich ein Zwischenspeicher zum Zwischenspeichern des Datenausgangssignals. An dem Testdatenausgang 48 ist ebenfalls ein Zwischenspeicher zum Zwischenspeichern einer neuen Signatur oder eines Testmusters nach einer seriellen Schieberegisteroperation vorgesehen. Die logische Vergleichschaltung 26 ist vorzugsweise als eine XOR-Schaltung ausgebildet, die sich zwischen dem Zwischenspeicher am Testdateneingang 1, dem Dateneingang 2 und dem Zwischenspeicher am Testdatenausgang 48 befindet. Die Schaltungszelle 1 gemäß der Erfindung zur Testmustergenerierung und Testmusterkompression ermöglicht die Kompression von Daten mit einer bereits vorhandenen Signatur ohne die Daten auf ihrem Wege vom Dateneingang 2 zum Datenausgang 51 zu verändern.

Für das Einlesen eines neuen Testmusters vom Testdateneingang 1 zum Datenausgang wird die Testdateneinkoppelschaltung 6 verwendet, die über den Rückkopplungssignalpfad 67 der Zwischenspeicher mittels eines Multiplexers 6-3 Testdaten in den Datensignalpfad einkoppeln kann. Diese Einkopplung erfolgt ohne zusätzliche Signallaufzeitverzögerungen im Datensignalpfad zwischen dem Testdateneingang 1 und dem Speicherzellen-Datensignalausgang 51.

Die Anzahl der notwendigen Schaltungselemente im Datensignalpfad ist bei der erfindungsgemäßen Schaltungszelle minimal, so dass die Schaltgeschwindigkeit der Schaltungszelle und eines Registers, das aus mehreren dieser Schaltungszellen aufgebaut ist, erheblich gesteigert wird.

Die erfindungsgemäße Anordnung der Schaltungszelle ermöglicht es, Testdaten in den Datenpfad zwischen den Dateneingang und den Datenausgang zu schalten, ohne den Datenpfad zu verändern, der in einem Operationsbetrieb aktiv ist. Darüber hinaus werden die Testdaten auch über den Rückkopplungssignalpfad ausgelesen. Dadurch entsteht keine zusätzliche Fan-Out-Belastung des Datenausgangs. Dies ist insbesondere bedeutend, wenn die Registerschaltungszellen voneinander in großem Abstand auf der integrierten Schaltung plaziert und somit die Signalleitungslängen groß sind und eine hohe kapazitive Last darstellen. Die Vermeidung der zusätzlichen Fan-Out-Belastung des Datenausgangs durch die erfindungsgemäße Anordnung der Schaltungszelle vermeidet zusätzlich Signalverzögerungen durch kapazitive Last aufgrund großer Leitungslängen zwischen den Schaltungszellen.

### Bezugszeichenliste

- 1: Testdatensignaleingang
- 2: Datensignaleingang
- 3: Taktsignaleingang
- 4: Leitung
- 5: Signaleingang der Testdatenkoppelschaltung
- 6: Testdatenkoppelschaltung
- 7: Leitung
- 8: Signaleingang
- 9: Testdateneingabe-Zwischenspeicher
- 10: Leitung
- 11: Takteingang
- 12: Taktleitung
- 13: Takteingang
- 14: Taktleitung
- 15: Testdatenausgang der Testdatenkoppelschaltung
- 16: Datenausgang der Testdatenkoppelausschaltung
- 17: Steueranschluß
- 18: Steuerleitung
- 19: Datenleitung
- 20: Signaleingang der Schalteinrichtung
- 21: Schalteinrichtung
- 22: Signaleingang der Schalteinrichtung
- 23: Signalausgang der Schalteinrichtung
- 24: Steueranschluß
- 25: Steuerleitung
- 26: Vergleichschaltung
- 27: Signaleingang Vergleichsschaltung
- 28: Signaleingang der Vergleichsschaltung
- 29: Signalausgang der Vergleichsschaltung
- 30: Leitung
- 31: Ausgang des Testdaten-Eingabe-Zwischenspeichers
- 32: Leitung
- 33: Verzweigungsknoten
- 34: Leitung
- 35: Leitung
- 36: Signaleingang des Testdaten-Ausgabe-Zwischenspeichers
- 37: Testdaten-Ausgabe-Zwischenspeicher
- 38: Leitung
- 39: Signaleingang des Datenausgabe-Zwischenspeichers
- 40: Datenausgabe-Zwischenspeicher
- 41: Takteingang
- 42: Takteingang
- 43: Taktleitung
- 44: Taktleitung
- 45: Inverter
- 46: Ausgang des Testdaten-Ausgabe-Zwischenspeichers
- 47: Leitung
- 48: Speicherzelle-Testdaten-Signalausgang
- 49: Ausgang des Datenausgabe-Zwischenspeichers
- 50: Leitung
- 51: Schaltungszellen-Datensignalausgang
- 52: Multiplexer-Signaleingang
- 53: Leitung
- 54: Multiplexer-Signalausgang
- 55: Leitung
- 56: Multiplexer-Signaleingang
- 57: Leitung
- 58: Multiplexer-Signalausgang
- 59: Leitung
- 60: Multiplexer-Signaleingang
- 61: Rückkoppelleitung
- 62: Abzweigungsknoten
- 63: Multiplexer-Signaleingang
- 64: Rückkoppelleitung
- 65: Abzweigungsknoten
- 66: Steuerleitung
- 67: Rückkopplungssignalleitung
- 68: Verzweigungsknoten
- 69: Rückkoppelleitung
- 70: Rückkoppelleitung
- 71: Multiplexer-Signaleingang
- 72: Multiplexer-Signaleingang
- 73: Taktleitung
- 74: Taktleitung
- 75: Taktleitung

## Patentansprüche

1. Schaltungszelle zur Datenspeicherung, Testmuster-Generierung und Testmuster-Kompression von Schaltungen mit eingebauter Selbsttestfunktion, welche aufweist:
eine Testdaten-Einkoppelschaltung (6), die einen Testdateneingang (5) zum Empfangen eines Testdateneingangsignals TDI von einer vorgeschalteten Schaltungszelle, das in einem Testdaten-Zwischenspeicher (6-1, 6-3) speicherbar ist, einen Dateneingang (8) zum Anlegen eines Dateneingangsignals DI, das in einem Daten-Zwischenspeicher (6-2, 6-3) speicherbar ist, einen Testdatenausgang (15) zur Abgabe des zwischengespeicherten Testdatensignals TD und einen Datenausgang (16) zur Abgabe des zwischengespeicherten Datensignals D an einen Datensignalpfad über einen Datensignalausgang (51) der Schaltungszelle aufweist,
wobei die beiden Zwischenspeicher (6-1, 6-3; 6-2, 6-3) der Testdaten-Einkoppelschaltung(6) jeweils aus einem Multiplexer (6-1; 6-2) und einem Rückkopplungs-Multiplexer (6-3) zum Rückkoppeln eines Signalausgangs (54; 58) des Multiplexers (6-1; 6-2) über einen Rückkopplungs-Signalpfad (67) an einen Signaleingang (71; 72) des Multiplexers (6-1; 6-2) bestehen und
wobei über den gemeinsamen Rückkopplungs-Signalpfad (67) das empfangene Testdateneingangssignal TDI in den Datensignalpfad in Abhängigkeit von einem an die Testdaten-Einkoppelschaltung(6) angelegten ersten Steuersignal TEST koppelbar ist;
und mit
einer logischen Vergleichsschaltung (26), die das Testdateneingangssignal TDI mit dem von der Testdaten-Einkoppelschaltung(6) abgegebenen Testdatensignal TD zum Erzeugen eines Vergleichssignals vergleicht, das an eine Schalteinrichtung (21) angelegt wird, die in Abhängigkeit von einem zweiten Steuersignal SCAN das erzeugte Vergleichsignal oder das von der Testdaten-Einkoppelschaltung(6) abgegebene Testdatensignal TD an einen Testdatensignalausgang (48) der Schaltungszelle durchschaltet, wobei mittels des Rückkopplungs-Multiplexers (6-3), der durch das erste Steuersignal TEST gesteuert wird, das Testdatensignal TD oder das Datensignal D auf den Rückkopplungssignalpfad (67) schaltbar sind.

2. Schaltungszelle nach Anspruch 1
**dadurch gekennzeichnet,**
**dass** durch Verbinden des Testdatensignalausgangs (48) einer Schaltungszelle mit dem Testdateneingang (1) einer nachgeschalteten Schaltungszelle ein BILBO-Register gebildet wird.

3. Schaltungszelle nach einem der vorangehenden Ansprüche
**dadurch gekennzeichenet,**
dass der Rückkopplungs-Multiplexer (6-3) zwei Signaleingänge (60,63) aufweist,
wobei der erste Signaleingang (60) mit dem Signalausgang (54) des Multiplexers (6-1) des Testdaten-Zwischenspeichers und der zweite Signaleingang (63) mit dem Signalausgang des Multiplexers (6-2) des Datenzwischenspeichers verbunden ist, und
wobei der Rückkopplungs-Multiplexer (6-3) durch das erste Steuersignal TEST derart steuerbar ist, das der Signalausgang des Multiplexers (6-1) des Testdaten-Zwischenspeichers an einen Signaleingang (72) des Multiplexers (6-2) des Datenzwischenspeichers zum Einkoppeln der Testdaten geschaltet wird.

4. Schaltungszelle nach einem der vorangehenden Ansprüche
**dadurch gekennzeichnet,**
**dass** der Multiplexer (6-1) des Testdatenzwischenspeichers zwei schaltbare Signaleingänge (52, 71) aufweist, wobei an dem ersten Signaleingang (52) das Testdateneingangsignal anliegt und der zweite Signaleingang (71) mit dem Ausgang des Rückkopplungs-Multiplexers (6-3) verbunden ist.

5. Schaltungszelle nach einem der vorangehenden Ansprüche
**dadurch gekennzeichnet,**
**dass** der Multiplexer (6-2) des Datenzwischenspeichers zwei schaltbare Signaleingänge (56,72) aufweist, wobei an den ersten Signaleingang (56) das Datensignal anliegt und der zweite Signaleingang (72) mit dem Ausgang des Rückkopplungs-Multiplexers (6-3) verbunden ist.

6. Schaltungszelle nach einem der vorangehenden Ansprüche
**dadurch gekennzeichnet,**
**dass** die logische Vergleichschaltung (26) ein XOR-Gatter ist.

7. Schaltungszelle nach einem der vorangehenden Ansprüche
**dadurch gekennzeichnet,**
**dass** die Schalteinrichtung (21) ein Multiplexer ist.

8. Schaltungszelle nach einem der vorangehenden Ansprüche
**dadurch gekennzeichnet,**
**dass** zwischen dem Datenausgang (16) der Testdaten-Einkoppelschaltung(6) und dem Datensignalausgang (51) der Schaltungszelle ein getakteter Daten-Ausgabe-Zwischenspeicher (40) vorgesehen ist.

9. Schaltungszelle nach einem der vorangehenden Ansprüche
**dadurch gekennzeichnet,**
**dass** zwischen dem Testdatenausgang (48) der Schaltungszelle und der Schalteinrichtung (21) ein getakteter Testdaten-Ausgabezwischenspeicher (37) vorgesehen ist.

10. Schaltungszelle nach einem der vorangehenden Ansprüche
**dadurch gekennzeichnet,**
**dass** die Testdaten-Einkoppelschaltung(6) über einen Takteingang (13) ein Taktsignal zum Takten der Multiplexer empfängt.

11. Schaltungszelle nach einem der vorangehenden Ansprüche
**dadurch gekennzeichnet,**
**dass** der Datenausgabe-Zwischenspeicher (40) und der Testdatenausgabe-Zwischenspeicher (37) jeweils über einen Takteingang (42, 41) ein Taktsignal empfangen, das zu dem Takteingangsignal der Testdaten-Einkoppelschaltung(6) invertiert ist.

12. Schaltungszelle nach einem der vorangehenden Ansprüche
**dadurch gekennzeichnet,**
**dass** das Testdateneingangssignal TDI in einem getakteten Testdateneingabe-Zwischenspeicher (9) zum Vergleich mit dem Testdatensignal TD durch die Vergleichschaltung (26) zwischengespeichert wird.

13. Schaltungszelle nach einem der vorangehenden Ansprüche
**dadurch gekennzeichnet,**
**dass** der Datenausgabe-Zwischenspeicher (40), der Testdatenausgabe-Zwischenspeicher (37) und der Testdateneingabe-Zwischenspeicher (9) jeweils durch eine Latch-Schaltung gebildet werden, die einen rückgekoppelten Multiplexer enthält.

14. Schaltungszelle nach einem der vorangehenden Ansprüche
**dadurch gekennzeichnet,**
**dass** die Datenspeicherung und die Testmusterkompression gleichzeitig erfolgt, wobei die gespeicherten Daten unverändert bleiben.

## Claims

1. Circuit cell for data storage, test pattern generation and test pattern compression of circuits with a built-in self-test function, which has:
a test data coupling-in circuit (6) having a test data input (5) for receiving a test data input signal TDI from a circuit cell connected upstream, which signal can be stored in a test data buffer store (6-1, 6-3), a data input (8) for applying a data input signal DI, which can be stored in a data buffer store (6-2, 6-3), a test data output (15) for outputting the buffer-stored test data signal TD, and a data output (16) for outputting the buffer-stored data signal D to a data signal path via a data signal output (51) of the circuit cell,
the two buffer stores (6-1. 6-3; 6-2, 6-3) of the test data coupling-in circuit (6) each comprising a multiplexer (6-1; 6-2) and a feedback multiplexer (6-3) for feeding back a signal output (54; 58) of the multiplexer (6-1; 6-2) via a feedback signal path (67) to a signal input (71; 72) of the multiplexer (6-1; 6-2) and
via the common feedback signal path (67), the received test data input signal TDI can be coupled into the data signal path in a manner dependent on a first control signal TEST applied to the test data coupling-in circuit (6); and having
a logical comparison circuit (26), which compares the test data input signal TDI with the test data signal TD output by the test data coupling-in circuit (6) in order to generate a comparison signal which is applied to a switching device (21) which, in a manner dependent on a second control signal SCAN, switches through the generated comparison signal or the test data signal TD output by the test data coupling-in circuit (6) to a test data signal output (48) of the circuit cell, a multiplexer (6-3), which is controlled by the first control signal TEST, enabling the test data signal TD or the data signal D to be switched onto the feedback signal path (67).

2. Circuit cell according to Claim 1,
**characterized**
**in that** a BILBO register is formed by connecting the test data signal output (48) of one circuit cell to the test data input (1) of a circuit cell connected downstream.

3. Circuit cell according to one of the preceding claims,
**characterized**
**in that** the feedback multiplexer (6-3) has two signal inputs (60, 63), the first signal input (60) being connected to the signal output (54) of the multiplexer (6-1) of the test data buffer store and the second signal input (63) being connected to the signal output of the multiplexer (6-2) of the data buffer store, and the feedback multiplexer (6-3) being controllable by the first control signal TEST in such a way that the signal output of the multiplexer (6-1) of the test data buffer store is switched to a signal input (72) of the multiplexer (6-2) of the data buffer store for coupling in the test data.

4. Circuit cell according to one of the preceding claims,
**characterized**
**in that** the multiplexer (6-1) of the test data buffer store has two switchable signal inputs (52, 71), the test data input signal being present at the first signal input (52) and the second signal input (71) being connected to the output of the feedback multiplexer (6-3).

5. Circuit cell according to one of the preceding claims,
**characterized**
**in that** the multiplexer (6-2) of the data buffer store has two switchable signal inputs (56, 72), the data signal being present at the first signal input (26) and the second signal input (72) being connected to the output of the feedback multiplexer (6-3).

6. Circuit cell according to one of the preceding claims,
**characterized**
**in that** the logical comparison circuit (26) is an XOR gate.

7. Circuit cell according to one of the preceding claims,
**characterized**
**in that** the switching device (21) is a multiplexer.

8. Circuit cell according to one of the preceding claims,
**characterized**
**in that** a clocked data output buffer store (40) is provided between the data output (16) of the test data coupling circuit (6) and the data signal output (51) of the circuit cell.

9. Circuit cell according to one of the preceding claims,
**characterized**
**in that** a clocked test data output buffer store (37) is provided between the test data output (48) of the circuit cell and the switching device (21).

10. Circuit cell according to one of the preceding claims,
**characterized**
**in that** the test data coupling circuit (6) receives a clock signal for clocking the multiplexers via a clock input (13).

11. Circuit cell according to one of the preceding claims,
**characterized**
**in that** the data output buffer store (40) and the test data output buffer store (37) in each case receive, via a clock input (42, 41), a clock signal which is inverted with respect to the clock input signal of the test data coupling circuit (6).

12. Circuit cell according to one of the preceding claims,
**characterized**
**in that** the test data input signal TDI is buffer-stored in a clocked test data input buffer store (9) for comparison with the test data signal TD by the comparison circuit (26).

13. Circuit cell according to one of the preceding claims,
**characterized**
**in that** the data output buffer store (40), the test data output buffer store (37) and the test data input buffer store (9) are in each case formed by a latch circuit containing a feedback multiplexer.

14. Circuit cell according to one of the preceding claims,
**characterized**
**in that** the data storage and the test pattern compression are effected simultaneously, the stored data remaining unchanged.

## Revendications

1. Cellule de circuit pour la mémorisation de données, la production de motifs de test et la compression de motifs de test de circuits avec une fonction intégrée de test automatique, qui comporte :
un circuit (6) d'injection de données de test, qui comporte une entrée (5) de données de test pour la réception d'un signal TDI d'entrée de données de test, qui peut être mémorisé dans une mémoire intermédiaire (6-1, 6-3) de données de test, à partir d'une cellule de circuit branchée en amont, une entrée de données (8) pour l'application d'un signal DI d'entrée de données, qui peut être mémorisée dans une mémoire intermédiaire de données (6-2, 6-3), une sortie (15) de données de test pour la délivrance du signal TD de données de tête mémorisé temporairement, et une sortie de données (16) pour la délivrance d'un signal de données D mémorisé temporairement à une voie de transmission du signal de données par l'intermédiaire d'une sortie (51) du signal de données de la cellule de circuit,
dans laquelle les deux mémoires intermédiaires (6-1, 6-3; 6-2, 6-3) du circuit (6) d'injection de données de test sont constituées chacune par un multiplexeur (6-1; 6-2) et par un multiplexeur de rétroaction (6-3) pour le couplage par rétroaction d'une sortie (54;58) de signaux du multiplexeur (6-1; 6-2) à une entrée de signaux (71;72) du multiplexeur (6-1; 6-2) par l'intermédiaire d'un trajet (67) de signal de rétroaction, et
dans laquelle le signal reçu TDI d'entrée de données peut être couplé par l'intermédiaire du trajet commun (67) du signal de rétroaction, dans la voie du signal de données en fonction d'un premier signal TEST appliqué au circuit (6) d'injection de données de test, et
comportant un circuit comparateur logique (26), qui compare le signal TDI d'entrée de données de test au signal TD de données de test délivré par le circuit (6) d'injection de données de test, pour produire un signal de comparaison, qui est appliqué à un dispositif de commutation (21), en fonction d'un second signal de commande SCAN, transmet le signal de comparaison produit ou le signal TD de données de test, délivré par le circuit (6) d'injection de données de test, à la sortie (48) du signal de données de test de la cellule de circuit, le signal TD de données de test ou le signal de données D pouvant être commutés sur le trajet (67) du signal de rétroaction au moyen du multiplexeur de rétroaction (6-3), qui est commandé par le premier signal de commande TEST.

2. Cellule de circuit selon la revendication 1, **caractérisée en ce qu'**un registre BILBO est formé par réunion de la sortie (48) du signal de données de test d'une cellule de circuit à l'entrée (1) de données de test d'une cellule de circuit branchée en aval.

3. Cellule de circuit selon l'une des revendications précédentes, **caractérisée en ce**
**que** le multiplexeur de rétroaction (6-3) comporte deux entrées de signaux (60,63),
dans laquelle la première entrée de signaux (60) est reliée à la sortie de signaux (54) du multiplexeur (6-1) de la mémoire intermédiaire de données de test et la seconde entrée de signaux (63) est reliée à la sortie de signaux du multiplexeur (6-2) de la mémoire intermédiaire de données, et
dans laquelle le multiplexeur de rétroaction (6-3) peut être commandé par le premier signal de commande TEST, qui est transmis de telle sorte que la sortie de signaux du multiplexeur (6-1) de la mémoire intermédiaire de données de test est connectée à une entrée de signaux (72) du multiplexeur (6-2) de la mémoire intermédiaire de données pour l'injection des données de test.

4. Cellule de circuit selon l'une des revendications précédentes, **caractérisée en ce que** le multiplexeur (6-1) de la mémoire intermédiaire de données de test comporte deux entrées de signaux commutables (52,71), le signal d'entrée de données de test étant appliqué à la première entrée de signaux (52) et la seconde entrée de signaux (61) étant reliée à la sortie du multiplexeur de rétroaction (6-3).

5. Cellule de circuit selon l'une des revendications précédentes, **caractérisée en ce que** le multiplexeur (6-2) de la mémoire intermédiaire de données comporte deux entrées de signaux commutables (56,72), le signal de données étant appliqué à la première entrée de signaux (56) et la seconde entrée de signaux (72) étant reliée à la sortie du multiplexeur de rétroaction (6-3).

6. Cellule de circuit selon l'une des revendications précédentes, **caractérisée en ce que** le circuit comparateur logique (26) est une porte OU-EXCLUSIF.

7. Cellule de circuit selon l'une des revendications précédentes, **caractérisée en ce que** le dispositif de commutation (21) est un multiplexeur.

8. Cellule de circuit selon l'une des revendications précédentes, **caractérisée en ce qu'**une mémoire intermédiaire de sortie de données (40) commandée de façon cadencée est prévue entre la sortie de données (16) du circuit (6) d'injection de données de test et la sortie (50) de signaux de données de la cellule de circuit.

9. Cellule de circuit selon l'une des revendications précédentes, **caractérisée en ce qu'**une mémoire intermédiaire de sortie de données de test (37) commandée de façon cadencée est prévue entre la sortie (48) de données de test de la cellule de circuit et le dispositif de commutation (21).

10. Cellule de circuit selon l'une des revendications précédentes, **caractérisée en ce que** le circuit (6) d'injection de données de test reçoit, par l'intermédiaire d'une entrée de cadence (13), un signal de cadence pour commander de façon cadencée les multiplexeurs.

11. Cellule de circuit selon l'une des revendications précédentes, **caractérisée en ce que** la mémoire intermédiaire de sortie de données (40) et la mémoire intermédiaire de sortie de données de test (37) reçoivent, respectivement par l'intermédiaire d'une entrée de cadence (42,41), un signal de cadence, qui est inversé par rapport au signal d'entrée de cadence du circuit (6) d'injection de données de test.

12. Cellule de circuit selon l'une des revendications précédentes, **caractérisée en ce que** le signal TDI d'entrée de données de test est mémorisé temporairement dans une mémoire intermédiaire d'entrée de données de test (9) commandée de façon cadencée, pour comparaison au signal de données de test TD par le circuit comparateur (26).

13. Cellule de circuit selon l'une des revendications précédentes, **caractérisée en ce que** la mémoire intermédiaire (40) de sortie de données, la mémoire intermédiaire (37) de sortie de données de test et la mémoire intermédiaire (9) d'entrée de données de test sont formées respectivement par un circuit de verrouillage, qui contient un multiplexeur couplé par rétroaction.

14. Cellule de circuit selon l'une des revendications précédentes, **caractérisée en ce que** la mémorisation de données et la composition de motifs de test s'effectuent simultanément, les données mémorisées restant inchangées.
